# EUROPÄISCHE PATENTSCHRIFT

(11) **EP 1 425 638 B1**
(45) Veröffentlichungstag und Bekanntmachung des Hinweises auf die Patenterteilung: **22.06.2005**
(21) Anmeldenummer: 02797642.2
(22) Anmeldetag: 29.08.2002
(51) Int. Cl.: G05B 17/02

(54) **VERFAHREN ZUR VALIDIERUNG VON SIMULATIONSERGEBNISSEN EINES SYSTEMS SOWIE DARAUF AUFBAUENDER ÄQUIVALENZVERGLEICH DIGITALER SCHALTUNGEN**
METHOD FOR VALIDATING SIMULATION RESULTS OF A SYSTEM AND EQUIVALENCE COMPARISON OF DIGITAL CIRCUITS BASED ON SAID METHOD
PROCEDE DE VALIDATION DE RESULTATS DE SIMULATION D'UN SYSTEME ET COMPARAISON D'EQUIVALENCE DE CIRCUITS NUMERIQUES SUR LA BASE DE CE PROCEDE

(30) Priorität: 03.09.2001 DE 10143101
(43) Veröffentlichungstag der Anmeldung: 09.06.2004
(73) Patentinhaber: Infineon Technologies AG, 81669 München (DE)
(72) Erfinder: DRECHSLER, Rolf, 28359 Bremen (DE); GÜNTHER, Wolfgang, 81737 München (DE); STUBERT, Burkhard, 81739 München (DE)
(74) Vertreter: Banzer, Hans-Jörg, Dipl.-Ing.
(86) Internationale Anmeldenummer: PCT/EP2002/009640
(87) Internationale Veröffentlichungsnummer: WO 2003/021366

(56) Entgegenhaltungen:
- US-A- 5 867 399
- US-A- 5 870 588
- US-A- 6 154 719

## Beschreibung

Die Erfindung betrifft ein Verfahren zur Validierung von Simulationsergebnissen eines Systems, wobei dieses System in eine Mehrzahl von Abstraktionsebenen unterschiedlicher Komplexität unterteilt ist, sowie ein darauf aufbauendes Verfahren zum Äquivalenzvergleich digitaler Schaltungen, wobei jede digitale Schaltung durch eine Mehrzahl von zunächst als frei belegbar angenommenen Zustandsvariablen sowie Eingangsvariablen beschrieben wird.

Durch die stark zunehmende Komplexität heutiger z.B. mikroelektronischer Systeme kommt es häufig vor, dass die Komponentenanzahl wie z.B. Transistoren oder Logikgatter mehrere Millionen übersteigt. Exemplarisch sei an dieser Stelle auf den computergestützten Schaltkreisentwurf verwiesen, da aktuelle Entwürfe hier oft aus bis zu 20 Millionen Transistoren bestehen.

Um diese Systeme effizient handhaben zu können, ist es notwendig Abstraktionsebenen einzuführen. Ausgehend von einer ersten Idee werden immer mehr Details hinzugefügt, bis eine vollständige Beschreibung entsteht.

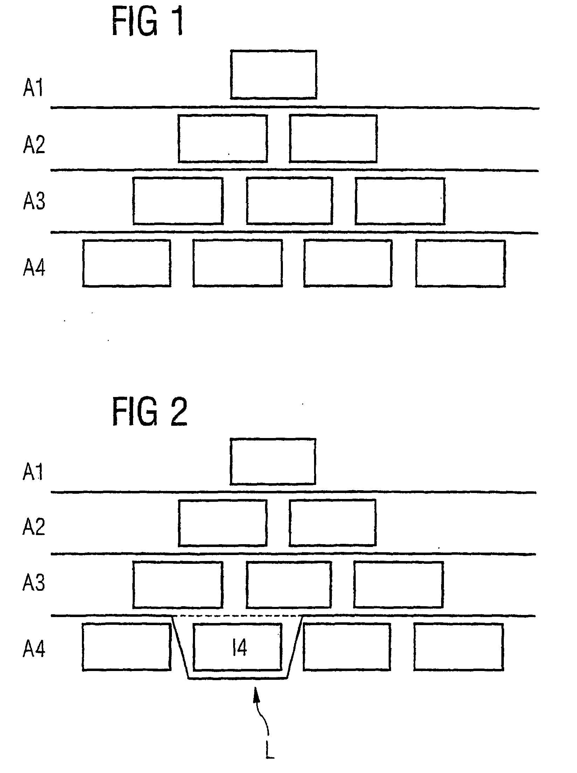

Die Verfeinerung am Beispiel des Schaltkreisentwurfs von der Spezifikation bis zur Realisierung in Gattern bzw. Transistoren ist in FIG 1 angegeben, wo ein System mit vier Abstraktionsebenen A1...A4 gezeigt ist. Der Begriff der Verfeinerung wird hierbei in naheliegender Weise von oben nach unten angewandt. Die entstehenden Schichten werden auch Ebenen genannt. Die Abstraktionsebene A1 beschreibt die Spezifikation, während die Abstraktionsebenen A2 und A3 weiter verfeinerte abstrakte Modelle des Systems beschreiben. Die unterste Abstraktionsebene A4 schließlich weist den höchsten Detaillierungsgrad auf, indem das System auf Ebene der Bauelemente wie Gatter, Transistoren etc. beschrieben wird. Die Abstraktionsebene A4 ist somit am komplexesten.

Diese Vorgehensweise der Verfeinerung wird auch als 'top down Entwicklung' bezeichnet, ausgehend von der Spezifikation bis zur Realisierung von Gattern bzw. Transistoren. Diese Beschreibung kann jedoch so viel Information enthalten, dass an manchen Stellen wieder Vereinfachungen notwendig sind. Da man sich durch die Vereinfachungen jedoch von der eigentlichen Beschreibung wieder entfernt, muss sichergestellt werden, dass bzw. in welcher Weise die Resultate, die für die höhere Abstraktionsebene erzielt wurden, auch für die weiter unten gelegenen gelten.

Man unterscheidet prinzipiell zwei Abstraktionsmethoden:

### - informationserhaltende Abstraktion:

Die Beschreibung wird vereinfacht und somit in der Komplexität reduziert, allerdings wird der Informationsgehalt bzgl. der betrachteten Ziele nicht beeinträchtigt. D.h. alle auf höheren Abstraktionsebenen erzielten Resultate sind unmittelbar übertragbar. Werden z.B. bei elektronischen Schaltkreisen Aussagen über das logische Verhalten gemacht, so können technologiespezifische Informationen wie der Leistungsverbrauch vernachlässigt werden.

### - informationsreduzierende Abstraktion:

Die Beschreibung wird in der Form vereinfacht, dass Details weggelassen werden und der Informationsgehalt bzgl. der Aufgabenstellung verringert wird. Dieses Vorgehen ermöglicht im Allgemeinen größere Reduktionen.

Allerdings muss in der Folge immer überprüft werden, ob die Resultate auf die nächste Abstraktionsebene transferierbar sind. An dieser Stelle ist für gewöhnlich viel "Handarbeit" notwendig, da die Ergebnisse in einzelnen Schritten verifiziert und auf die darunter liegende Ebene übertragen werden müssen. Somit kann festgehalten werden, dass es durch die stark anwachsende Anzahl an Komponenten in modernen komplexen Systemen oftmals notwendig ist, Abstraktionen einzuführen, die die Systeme für Simulationszwecke handhabbar machen. Durch diese Abstraktionen, die häufig vereinfachende Annahmen machen, können jedoch die Simulationsergebnisse beeinträchtigt werden.

Aus der US-A-5 867 399 ist ein Verfahren zur Extraktion einer implementierbaren Beschreibung einer Schaltung, wie beispielsweise einer RTL-Beschreibung, aus einer höherstufigen Beschreibung, beispielsweise einer VHDL-Beschreibung, bekannt. Dabei wird eine Benutzeroberfläche bereitgestellt, welche einem Entwickler das Entwerfen von Schaltungen erleichtert, und es werden die Möglichkeiten von Simulationen der Schaltung anhand verschiedener Beschreibungen erwähnt.

Aufgabe der vorliegenden Erfindung ist es daher, ein Verfahren zur automatischen Validierung von Simulationsergebnissen solcher technischer Systeme zu schaffen.

Diese Aufgabe wird gelöst durch ein Verfahren nach Anspruch 1. Die abhängigen Ansprüche definieren vorteilhafte oder bevorzugte Ausführungsbeispiele der Erfindung.

Die Erfinder haben nun erkannt, dass die Simulationsresultate, die die Unterschiede auf höheren Abstraktionsebenen hervorrufen, nur einen kleinen Teil der darunter liegenden Ebene betreffen. Ausgehend von dieser Erkenntnis wird erfindungsgemäß in automatischer Weise der relevante Systemteil extrahiert.

Gemäß der vorliegenden Erfindung wird dies erreicht, indem das Verfahren der eingangs genannten Art dahingehend weitergebildet wird, dass eine automatische Nachbearbeitung der Gültigkeit eines Simulationsergebnisses erfolgt. Dies wird erreicht, indem in automatischer Weise ein jeweils aktivierter und damit für die Simulation relevanter Systemteil extrahiert wird, wobei zur Komplexitätsreduktion die Abstraktionsebene, auf der die Simulation durchgeführt wurde, als Grundlage dient. Nur an aktivierten Stellen einer niedrigeren Abstraktionsebene des Systems wird diese Abstraktionsebene lokal durchbrochen und entsprechende höherkomplexe Systeminformation wird einbezogen, wobei eine Validierung nur auf dem extrahierten relevanten Systemteil erfolgt.

Damit werden unter anderem die folgenden Vorteile erzielt:
- während der Simulationsphase kann mit der Beschreibung auf hoher Abstraktionsebene gearbeitet werden. Somit wird die Komplexität reduziert und die Beschreibung leichter handhabbar;
- die Validierung geschieht nur auf dem relevanten Teil, und nach Erfahrungen betrifft dieser nur einen kleinen Teil des Gesamtsystems. Ein komplettes Auflösen der Ebene wird vermieden.

Damit werden die Vorteile beider Sichtweisen kombiniert, da einerseits die Komplexität reduziert und andererseits die Qualität des Resultates nicht beeinträchtigt wird.

Ein System S wird durch mehrere Verfeinerungen in Abstraktionsebenen Sᵢ aufgeteilt, wobei S₁ die höchste und Sₙ die niedrigste ist. Somit entsteht Sᵢ₋₁ aus Sᵢ durch Abstraktion. In der Darstellung nach FIG 1 entspricht die Spezifikation A1 der Ebene S₁ und die Gatter- bzw. Transistorenebene A4 der Ebene Sₙ. Die Endergebnisse müssen für die Ebene Sₙ angegeben werden, jedoch sind auf dieser Ebene bei komplexen Systemen häufig zu viele Details zu beachten, als dass man diese Beschreibung effizient bearbeiten kann.

Beispiel: Bei der Beschreibung digitaler Schaltungen ist die Modellierung auf Transistorebene nur für kleine Schaltungen mit ca. 1000 Elementen möglich. Durch die vereinfachende Annahme, die Schaltungen auf der Basis von 0 und 1 zu beschreiben, können Simulationen mit mehreren Millionen Transistoren durchgeführt werden.

Es muss aber berücksichtigt werden, ob es sich um eine informationserhaltende oder informationsreduzierende Abstraktion handelt. Diese Technik wird häufig eingesetzt, um die Effizienz auf höheren Ebenen zu steigern. Jedoch muss in diesem Fall in einer Nachbearbeitung sichergestellt werden, dass die Simulationsergebnisse auch auf der niedrigeren Ebene gelten.

Eine ähnliche Situation ergibt sich, wenn in einem komplexen System einzelne Komponenten unabhängig vom gesamten getestet werden. Falls es zu Fehlverhalten kommt, das durch eine Simulation aufgezeigt wird, so muss anschließend überprüft werden, ob die betrachtete Komponente im Zusammenspiel mit den anderen Teilen des Systems das gleiche Verhalten zeigen kann.

Beispiel: Eine Ampel besteht aus drei Lampen mit den Farben rot, gelb und grün. Testet man die Lampen einzeln, so ist es möglich, dass die rote und die grüne Lampe gleichzeitig leuchten. Werden die Lampen später in das komplette System integriert, so wird durch eine Kontrollschaltung ausgeschlossen, dass diese Situation auftritt.

Neben der Abstraktion muss demnach auch vorsichtig mit den Resultaten umgegangen werden, die man aus lokalen Betrachtungen gewinnt. Nur eine Auswertung im Gesamtsystem unter Berücksichtigung der späteren Umgebung gibt Aufschluss.

Grundgedanke der Erfindung ist also das lokale Aufweichen der Abstraktionsebenen, um die Simulationsergebnisse einerseits auf den niedrigeren Stufen zu validieren, aber andererseits die Komplexität des Systems klein und überschaubar zu halten. Bei Simulationsläufen sind im Allgemeinen nicht alle Teile des Systems betroffen. Es wird in automatischer Weise der aktivierte und dadurch für die Simulation relevante Teil extrahiert und an dieser Stelle die Abstraktionsebene lokal durchbrochen.

Dies ist in der Darstellung gemäß FIG 2 veranschaulicht, worin der Vorgang des lokalen Aufweichens mit L bezeichnet ist, indem das abstrakte Modell A3 nunmehr auch eine aktivierte Informationseinheit I4 der darunter liegenden Transistor- und

Gatterebene A4 einbezieht. Dadurch wird gewährleistet, dass die volle Information zur Verfügung steht, um die Simulationsresultate auch auf weiter unter gelegenen Ebenen auf Gültigkeit hin zu überprüfen. Andererseits kann die durch die Abstraktion erzielte Komplexitätsreduktion auf große Teile des Systems angewandt werden.

Ausgehend von diesem grundlegenden Erfindungsgedanken wird erfindungsgemäß ein Verfahren zum Äquivalenzvergleich digitaler Schaltungen vorgeschlagen, wobei jede digitale Schaltung durch eine Mehrzahl von zunächst als frei belegbar angenommenen Zustandsvariablen sowie Eingangsvariablen beschrieben wird und bei Feststellung eines Unterschiedes ein Gegenbeispiel generiert wird, welches zum Nachweis einer Inäquivalenz validiert wird, indem versucht wird,
- zunächst auf Basis von Simulationen eine Erreichbarkeit des Gegenbeispiels nachzuweisen, indem eine Sequenz von Mustern gesucht wird, die ausgehend von vollständig unspezifizierten Zustandsvariablen die für dieses Muster notwendige Belegung einstellt, und
- sofern dies nicht gelingt die Nicht-Erreichbarkeit dieses Gegenbeispiels durch eine Überapproximation zu beweisen, insbesondere auf Grundlage einer BDD (Binary Decision Diagramm)-Analyse, indem ausgehend von den möglichen Ziel-Zuständen des Gegenbeispiels iterativ solange vorausgehende Zustände, von denen aus die Ziel-Zustände erreichbar sind, ermittelt werden und einer Menge von Zuständen hinzugefügt werden, bis keine neuen Zustände mehr hinzugefügt werden können, wobei Nicht-Erreichbarkeit vorliegt, wenn in der Menge von Zuständen nicht alle Zustände erreicht wurden und damit die Zielzustände des Gegenbeispiels von jedem Ausgangszustand nicht erreichbar sind.

Dabei hat es sich als besonders günstig erwiesen, wenn ein Nachweis der Erreichbarkeit des Gegenbeispiels auf der Grundlage von Zufallsmustersimulationen erfolgt, indem zunächst alle Zustandsvariablen mit einem unbestimmten Wert (don't care) belegt werden und Folgezustände iterativ ermittelt werden, indem die Eingangsvariablen der digitalen Schaltung solange mit Zufallswerten beaufschlagt werden, bis der gewünschte Zielzustand des Gegenbeispiels erreicht wird oder eine vorgegebene Anzahl von Iterationen überschritten wird.

Alternativ kann ein Nachweis der Erreichbarkeit des Gegenbeispiels auch auf der Grundlage von evolutionären Algorithmen erfolgen.

Nach einer vorteilhaften Ausgestaltung erfolgt ein Nachweis der Nicht-Erreichbarkeit durch Überapproximation, indem ein relevanter Systemteil des Gegenbeispiels extrahiert wird,
- wobei eine Teilschaltung generiert wird, indem eine Beschränkung auf solche schwierigen Zustandsvariablen erfolgt, die stets oder häufig auf einem unbestimmten Wert verbleiben,
- wobei bei Nicht-Erreichbarkeit der Teilschaltung auf eine Nicht-Erreichbarkeit des gesamten Gegenbeispiels geschlossen wird.

Dabei hat es sich als weiter vorteilhaft erwiesen, wenn eine Beschränkung auf solchermaßen schwierige Zustandsvariablen erfolgt, indem das Gegenbeispiel um alle oder einen Teil solcher Zustandsvariablen reduziert wird, die häufig den geforderten Zielzustand des Gegenbeispiels einnehmen.

Wenn eine Reduzierung des Gegenbeispiels um Zustandsvariablen, die häufig den geforderten Zielzustand des Gegenbeispiels einnehmen, dadurch erfolgt, dass diese auf einen unbestimmten Wert gesetzt werden, so lässt sich dies besonders einfach und damit effektiv erreichen.

Solche Zustandsvariablen, die häufig den geforderten Zielzustand des Gegenbeispiels einnehmen, lassen sich besonders vorteilhaft auf Grundlage einer Zufallsmustersimulation wie vorangehend beschrieben ermitteln.

Alternativ kann zum Nachweis der Nicht-Erreichbarkeit die Überapproximation dadurch erfolgen, dass ein relevanter Systemteil des Gegenbeispiels extrahiert wird,
- wobei eine Teilschaltung generiert wird, indem Zustandsvariablen durch Eingangsvariablen substituiert werden,
- wobei bei Nicht-Erreichbarkeit der Teilschaltung auf eine Nicht-Erreichbarkeit des gesamten Gegenbeispiels geschlossen wird.

Nach einer vorteilhaften Ausgestaltung dieser Alternative erfolgt eine inkrementelle Substitution solcher Zustandsvariablen durch Eingangsvariablen, die ausgehend von allen Zustandsvariablen, die im Einflussgebiet des Gegenbeispiels liegen, von der größten Anzahl an Variablen abhängen.

Als besonders effektiv hat es sich erwiesen, wenn eine erste Überapproximation gemäß der ersten aufgezeigten Möglichkeit zur Durchführung einer Überapproximation erfolgt und, falls so noch keine Nicht-Erreichbarkeit nachgewiesen werden konnte, eine weitere Überapproximation gemäß der voranstehend beschriebenen alternativen Überapproximation erfolgt, wobei solche Zustandsvariablen, die im Gegenbeispiel belegt sind, nicht durch Eingangsvariablen substituiert werden.

Wenn der Grad der Überapproximation vorgebbar ist, indem die Anzahl der zu substituierenden Zustandsvariablen variiert wird, so ergeben sich weitere Möglichkeiten zur Durchführung des erfindungsgemäßen Verfahrens, die die Flexibilität der Anwendung und weitere Optimierungen ermöglichen.

Eine erste vorteilhafte Ausgestaltung ergibt sich, wenn zunächst ein maximaler Grad an Überapproximation erfolgt, welcher sukzessive verringert wird.

Weiter hat sich bei Versuchen mit der Erfindung folgende Sequenz einer Überapproximation als besonders günstig erwiesen, wobei diese solange fortgesetzt wird, bis eine Nicht-Erreichbarkeit nachgewiesen ist:
- ignoriere 75% des Gegenbeispiels und substituiere alle anderen Zustandsvariablen,
- ignoriere 75% des Gegenbeispiels und substituiere 75% der anderen Zustandsvariablen,
- ignoriere 75% des Gegenbeispiels und substituiere 25% der anderen Zustandsvariablen,
- ignoriere 75% des Gegenbeispiels und substituiere keine anderen Zustandsvariablen,
- benutze das gesamte Gegenbeispiel und substituiere alle anderen Zustandsvariablen und
- benutze das gesamte Gegenbeispiel und substituiere keine anderen Zustandsvariablen.

Weiter ist es von Vorteil, wenn Information, die bei einem Nachweis der Erreichbarkeit des Gegenbeispiels erhalten wird, zur Beschleunigung der anschließenden, insbesondere BDD-basierten, Nicht-Erreichbarkeis-Analyse verwendet wird.

Das erfindungsgemäße Verfahren zum Äquivalenzvergleich digitaler Schaltungen lässt sich weiter verbessern, indem der Erreichbarkeitsanalyse des generierten Gegenbeispiels eine Komprimierung des Gegenbeispiels vorausgeht. Dies wird erreicht, indem für jede Zustandsvariable und jede Eingangsvariable mit nicht unbestimmtem Wert dieser Wert auf einen unbestimmten Wert gelegt wird, worauf diese Zustandsvariable oder Eingangsvariable entfernt wird, wenn weiterhin der festgestellte Unterschied zwischen den zu überprüfenden digitalen Schaltungen auftritt, solange bis keine weitere Reduzierung mehr möglich ist.

Eine bevorzugte Verwendung des Verfahrens nach der vorliegenden Erfindung liegt somit in der Logikverifikation im computergestützten Schaltkreisentwurf. Damit kann die Erfindung bevorzugt mit einem Computersystem realisiert werden, das Softwareabschnitte umfasst, mit denen die vorangehend beschriebenen Verfahrensschritte gemäß der Erfindung ausgeführt werden, wenn diese Softwareabschnitte auf dem Computersystem ausgeführt werden.

Mit Hilfe der Erfindung kann somit anhand einer automatischen Nachbearbeitung die Gültigkeit des Ergebnisses einer Simulation sichergestellt werden. Dies wird in den meisten Fällen erreicht, ohne dass die vollständige Beschreibung, die im Allgemeinen zu komplex ist, wiederhergestellt werden muss. Die hier am Beispiel der Validierung von berechneten Gegenbeispielen im Äquivalenzvergleich digitaler Schaltungen beschriebene Methode ist auch in allen anderen Anwendungen einsetzbar, die eine analoge Formalisierung des Abstraktionsschrittes erlauben.

Weitere Details und Vorteile der Erfindung ergeben sich anhand des im Folgenden beschriebenen detaillierten Ausführungsbeispiels und in Verbindung mit den Figuren. Es zeigt:
- FIG 1: Aufteilung eines technischen Systems in Abstraktionsebenen,
- FIG 2: Lokales Aufbrechen einer Abstraktionsebene des in FIG 1 gezeigten technischen Systems,
- FIG 3: ein Ablaufdiagramm zur Darstellung der Vorgehensweise beim Äquivalenzvergleich zweier digitaler Schaltungsbeschreibungen und
- FIG 4: eines Beispiel einer Überapproximation durch Ersetzen von Zustandsvariablen durch Eingänge.

Im Folgenden soll die Erfindung anhand eines konkreten Ausführungsbeispiels einer Validierung von Gegenbeispielen im computergestützten Schaltkreisentwurf näher erläutert werden.

Die Beschreibungen sind sowohl auf Register-Transfer-Ebene (Register Transfer Level RTL) als auch auf Gatterebene möglich. Vergleiche können prinzipiell zwischen den jeweiligen Ebenen durchgeführt werden, d.h. RTL-Beschreibung gegen RTL-Beschreibung, RTL-Beschreibung gegen Gatternetzliste oder zwei Gatternetzlisten gegeneinander.

Ausgehend von der Entwurfsidee und einer RTL-Beschreibung wird beim Schaltungsentwurf eine entsprechende Gatternetzliste generiert, auf deren Grundlage dann eine Layoutsynthese erfolgt.

Durch sog. ,property checking' kann dann überprüft werden, ob ein Entwurf geforderte Eigenschaften erfüllt. Im Anschluss kommt es häufig zu Korrekturen, die auch als ,re-design' bezeichnet werden. An dieser Stelle kann der Äquivalenzvergleich verwendet werden, um die Gleichheit zweier RTL-Beschreibungen zu zeigen. In einem nächsten Schritt wird die Korrektheit der Synthese überprüft (RTL-Beschreibung gegen Gatternetzliste). Am Ende werden noch einige Änderungen an der Netzliste durchgeführt, z.B. durch Integration von Testlogik. Weiterhin sind meist noch Änderungen in letzter Minute notwendig, sogenannte ,engineering change orders'. Auch diese Schritte können mit einem Äquivalenzvergleich überprüft werden. Wobei hier zwei Gatternetzlisten miteinander verglichen werden. Durch diese Vorgehensweise können oft tagelang dauernde Simulationsläufe eingespart werden.

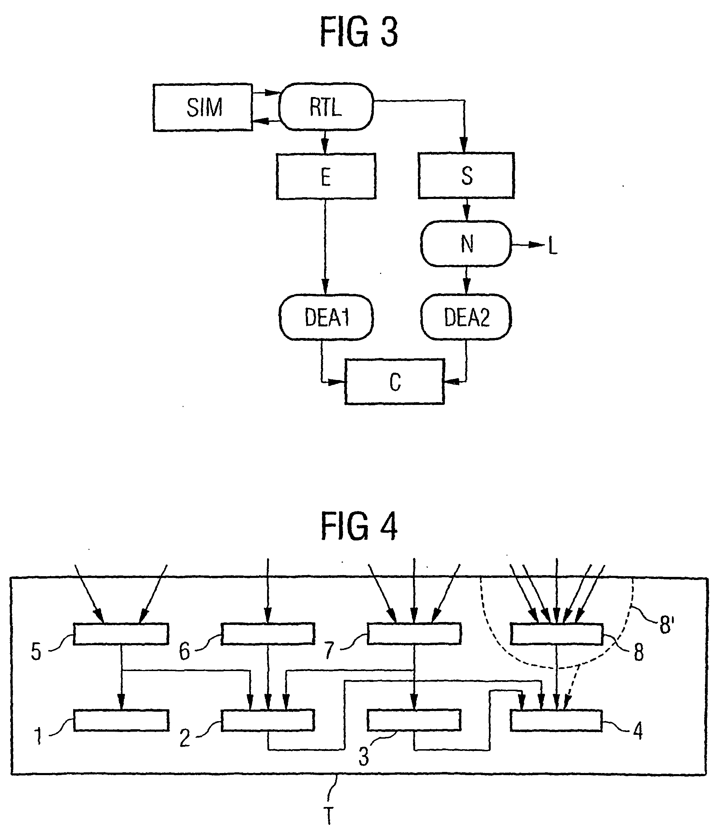

Durch den Äquivalenzvergleich wird die Funktionalität einer Schaltung überprüft. In der Darstellung gemäß FIG 3 ist anhand eines Ablaufdiagramms ein typisches Verifikationsszenario gezeigt, das sich bei der RTL- gegen Gatterebenenbeschreibung ergibt, um ein besseres Problemverständnis zu ermöglichen. Durch den Vergleich der RTL-Beschreibung und der Netzliste lässt sich die Korrektheit des Syntheseschrittes nachweisen. Ausgehend von einer RTL-Eingabe RTL, z.B. erhalten aus einer Simulation SIM, wird durch die Synthese eine Netzliste N erzeugt, die zur Layoutsynthese L dient. Ausgehend von der RTL-Beschreibung RTL wird durch eine Extraktion E eines entsprechenden Modells eines deterministischen endlichen Automaten DEA1 vorgenommen. Ebenso wird aus der Synthesenetzliste N ein solches Modell eines deterministischen endlichen Automaten DEA2 abgeleitet. Die beiden Modelle DEA1 und DEA2 werden nun in einem weiteren Schritt C auf Äquivalenz geprüft.

Es wird nun anhand eines solchen computergestützten Schaltkreisentwurfs aufgezeigt, wie die oben beschriebene erfindungsgemäße Methode zum Äquivalenzvergleich eingesetzt werden kann. Als Vorabbemerkung sei kurz auf den Unterschied von Schaltnetzen und Schaltwerken hingewiesen.
- Schaltnetz: Ein Schaltnetz lässt sich durch eine Boolesche Funktion beschreiben.
- Schaltwerk: Ein Schaltwerk besitzt auch speichernde Elemente. Das Verhalten von Schaltwerken lässt sich durch die bereits erwähnten deterministischen endlichen Automaten (DEA), im englischen Sprachgebrauch besser bekannt als 'Finite State Machines' FSM, beschreiben.

Ist man nur an der kombinatorischen Beschreibung interessiert, so kann ein Schaltwerk leicht durch folgende Abstraktion in ein Schaltnetz transformiert werden: Man trennt das Schaltwerk längs der speichernden Elemente, im Folgenden auch Zustandsvariablen genannt, auf. Somit ergeben sich neue Ein- und Ausgänge für die Schaltung. Der Vorteil dieser Abstraktion liegt in der Vereinfachung der Beschreibung, da nun nur noch das logische Verhalten betrachtet werden muss. Das zeitliche Verhalten wird vernachlässigt.

Somit kann es aber passieren, dass Simulationsergebnisse, die für das Schaltnetz berechnet werden, in der Schaltwerksbeschreibung nicht zulässig sind. Dies kann entstehen durch die Nicht-Erreichbarkeit von Zuständen im DEA. Daher muss, um die Simulationsergebnisse zu validieren, die Erreichbarkeit der Zustände nachgewiesen werden bzw. deren Nicht-Erreichbarkeit gezeigt werden.

Ein trivialer Ansatz wäre es, das gesamte Schaltwerk zu betrachten. Jedoch können heutige Schaltungen eine sehr große Anzahl mit mehr als 150.000 Zustandsvariablen besitzen, was einer Zustandsmenge von mehr als 2¹⁵⁰⁰⁰⁰ entspricht. Mit heute zur Verfügung stehenden Methoden ist eine solche Menge nicht effizient analysierbar.

Alle gängigen Werkzeuge zum Äquivalenzvergleich digitaler Schaltungen, die auf komplette ASICs (Application Specific Integrated Circuits) mit mehreren Millionen Gattern angewandt werden, machen daher die oben beschriebene vereinfachende Annahme. Durch diese Abstraktion wird implizit auch die Annahme gemacht, dass jeder Zustand des das Schaltwerk beschreibenden DEAs erreichbar ist, da die zu Eingängen transformierten Zustandsvariablen frei belegbar sind.

Die Werkzeuge zum Äquivalenzvergleich generieren daher zunächst ein Gegenbeispiel, wenn ein Unterschied erkennbar ist. Dieses Gegenbeispiel muss anschließend als erreichbar oder nicht-erreichbar nachgewiesen werden.

Die erfindungsgemäße Methode zur Validierung von Gegenbeispielen, die im Rahmen des Äquivalenzvergleichs bestimmt werden, besteht nun aus den Schritten:
1. Kompaktierung der Gegenbeispiele (optional)
2. Erreichbarkeitsanalye durch
2a. Simulationsbasierte Erreichbarkeitsanalyse und falls erforderlich
2b. BDD-basierten Beweis der Nicht-Erreichbarkeit

Diese Schritte werden nunmehr näher erläutert. Das im Folgenden beschriebene Verfahren wurde erfolgreich implementiert und an vielen praxisrelevanten Fällen erprobt.

### Kompaktierung der Gegenbeispiele

In der Praxis sind die generierten Gegenbeispiele häufig überspezifiziert, d.h. es werden mehr Eingangs- bzw. Zustandsvariablen belegt, als für den Nachweis der Inäquivalenz notwendig sind. Da das Ziel der Methode ist, nur die Bereiche zu betrachten, die für den Nachweis notwendig sind, wird versucht, die Länge der Gegenbeispiele zu reduzieren.

Um die Laufzeit gering zu halten, wird daher eine Heuristik eingesetzt, die ausgehend von dem Gegenbeispiel unter Verwendung eines dreiwertigen Simulators versucht, spezifizierte auf unbestimmte Werte, sogenannte don't cares dc, zu legen.

Dies erfolgt, indem für jede Zustandsvariable und jede Eingangsvariable mit nicht unbestimmtem Wert dc dieser Wert auf einen unbestimmten Wert dc gelegt wird, worauf diese Zustandsvariable oder Eingangsvariable entfernt wird, wenn weiterhin der festgestellte Unterschied zwischen den zu überprüfenden digitalen Schaltungen auftritt, solange bis keine weitere Reduzierung mehr möglich ist. Dazu wird der Reihe nach jeder spezifizierte Eingang ausgewählt und auf einen nicht spezifizierten Wert gesetzt. Ergibt die anschließende dreiwertige Simulation nach wie vor das gleiche Ergebnis, so wird der Wert unspezifiziert gelassen, andernfalls wird er zurückgesetzt. Ist der Unterschied also weiterhin zu beobachten, so wird das Muster reduziert. Dieser Prozess wird iteriert, bis keine Reduktion mehr möglich ist.

### Erreichbarkeitsanalyse

Die Erreichbarkeitsanalyse gliedert sich in zwei Schritte auf. Zunächst wird, da dies der weniger aufwändige Schritt ist, versucht, die Erreichbarkeit nachzuweisen. Gelingt dies nicht, wird ein Beweisverfahren gestartet, das versucht, die Nicht-Erreichbarkeit zu zeigen.

### Simulationsbasierte Erreichbarkeitsanalyse

Die Erreichbarkeit eines Gegenbeispiels ist nachgewiesen, wenn eine Sequenz von Mustern gefunden werden kann, die ausgehend von vollständig unspezifizierten Zustandsvariablen im Schaltwerk die für das Muster notwendige Belegung einstellt. In einer möglichen Implementierung werden Zufallsmuster simuliert.
Ebenfalls können gute Ergebnisse erreicht werden, wenn man die Simulation durch zusätzliche Informationen steuert, wie dies z.B. durch den Einsatz ,Evolutionärer Algorithmen' geschieht. Solche ,Evolutionärer Algorithmen' sind z.B. beschrieben in der Schrift: R. Drechsler. Evolutionary Algorithms in VLSI CAD, Kluwer Academic Publisher, 1998.

### BDD-basierter Beweis der Nicht-Erreichbarkeit

Eine direkte Methode des Beweises der Nicht-Erreichbarkeit kann durch eine BDD-basierte Erreichbarkeitsanalyse geschehen. Die Abkürzung BDD steht dabei für ,Binary Decision Diagramm'. Diese Technik wurde zu Beginn der 90er Jahre vorgeschlagen und ist ausgiebig beschrieben in: J.R. Burch, E.M. Clarke, K.L. McMillan, D.L. Dill; Sequential circuit verification using symbolic model checking, Design Automation Conference, S. 46-51, 1990.

Der Grundalgorithmus ist im Folgenden angegeben:

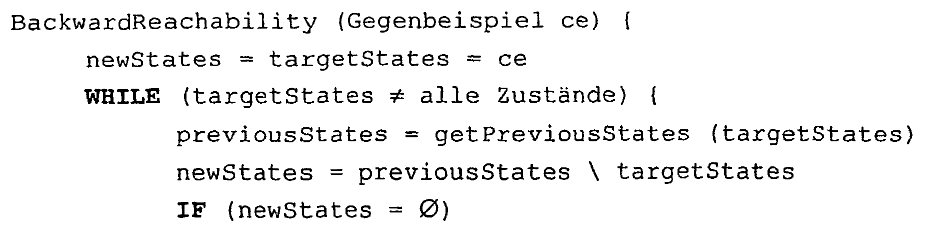

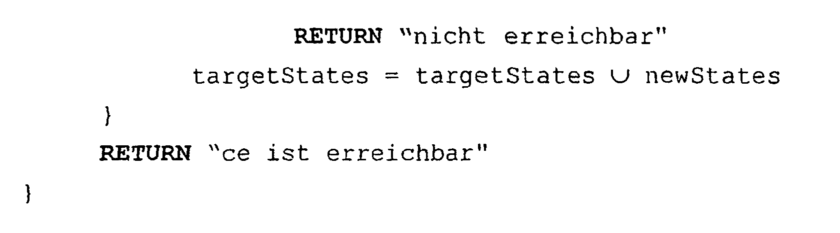

Zunächst muss unterschieden werden, ob man die Analyse auf der Übergangsrelation oder direkt auf der Zustandsübergangsfunktion ausführt. Auch eine Kombination ist möglich. Um die Komplexität zu reduzieren wurden Partitionierungsansätze vorgestellt, die jeweils nur einen Teil der Zustände betrachten (siehe z.B. die oben zitierte Schrift von Burch et al.). Jedoch können auch damit große Entwürfe nicht bearbeitet werden. Die wesentlichen Gründe dafür sind die BDD-Größen
- der Übergangsfunktion oder
- der Zielzustände (siehe "targetStates" im vorangehend dargestellten Grundalgorithmus).

In beiden Fällen ist die BDD-Größe der beschränkende Faktor. Daher werden im Weiteren zwei erfindungsgemäße Techniken angegeben, die versuchen, die Nicht-Erreichbarkeit zu beweisen.

### Beschränkung auf schwierige Zustände

Nach der oben angesprochenen Zufallsmustersimulation zeigt sich schon, dass es Zustandsvariablen gibt, die den im Gegenbeispiel geforderten Wert häufig annehmen, während andere Variablen immer auf dem Wert don't care dc bleiben. Daher werden zunächst die don't care dc Werte betrachtet, da es hier wahrscheinlich ist, dass diese Variablen nie mit den korrekten Werten belegt werden können. Wenn dies auch nur für einen Teil der Variablen gezeigt wird, so folgt daraus unmittelbar die Nicht-Erreichbarkeit des gesamten Gegenbeispiels.

An dieser Stelle wird klar, dass man sich nun zwischen den beiden zuvor gewählten Abstraktionsebenen befindet, also ein lokaler Aufbruch der Abstraktionsebenen erfolgt, da sowohl der sequentielle Aspekt des Schaltwerks (für die schwierigen Zustände) beachtet wird, als auch die Vereinfachung der Abstraktion, dass alle "nicht-schwierigen" als frei belegbare Eingänge behandelt werden.

Diese Methode ist eine Überapproximation, d.h. wenn Nicht-Erreichbarkeit für die generierte Teilschaltung bewiesen wird, so kann man auf die Gesamtschaltung schließen. Im anderen Fall erhält man keine Aussage.

### Substitution von Zustandsvariablen durch Eingänge

Eine weitere Überapproximation, die als Verallgemeinerung der obigen Methode gesehen werden kann, ist die Auswahl von Zustandsvariablen, die durch Eingänge ersetzt werden. Diese Vorgehensweise ist in FIG 4 veranschaulicht, die eine Teilschaltung T mit Zustandsvariablen in Form von Registern 1 bis 4 des Gegenbeispiels und mit weiteren Zustandsvariablen bzw. Registern 5 bis 8 im Einflussbereich des Gegenbeispiels zeigt. Eingänge sind in Form von Pfeilen, die zu den jeweiligen Registern führen, angedeutet. Exemplarisch wird das Register 8, welches in der Schicht über dem Gegenbeispiel und damit im Einflussbereich des Gegenbeispiels liegt, durch einen Eingang 8' ersetzt.

Die Substitution erfolgt inkrementell. Ausgehend von allen Zustandsvariablen 5 bis 8, die im Einflussbereich des Gegenbeispiels (transitive fanin cone) liegen, werden diejenigen ausgewählt, die von der größten Anzahl an Variablen abhängen (vgl. Register 8 mit fünf Eingängen). Dadurch kann die BDD-Größe stark reduziert werden, es sind aber auch andere Auswahlkriterien einsetzbar.

Zustandsvariablen, die im Gegenbeispiel belegt sind, werden nie ersetzt, da dies schon von der oben beschriebenen Methode betrachtet wird. Trotzdem kann die resultierende Schaltung noch immer sequentielles Verhalten aufweisen, selbst wenn alle Variablen ersetzt werden, z.B. wenn es Zustandsvariablen gibt, die von sich selbst abhängen.

Der Ablauf der erfindungsgemäßen Vorgehensweise gestaltet sich, knapp zusammengefasst, somit wie folgt: zunächst wird basierend auf Zufallsmustersimulationen versucht, die Erreichbarkeit eines Gegenbeispiels zu beweisen. Anschließend werden obige BDD-basierte Methoden eingesetzt.

Diese können mit verschiedenen Parametern gestartet werden, die den Grad der Überapproximation angeben, indem die Anzahl der zu ersetzenden Zustandsvariablen variiert wird.

Dabei hat sich folgende Sequenz einer Überapproximation als besonders erfolgreich erwiesen, die nach dem folgenden Schema solange durchgeführt wird, bis eine Nicht-Erreichbarkeit nachgewiesen ist:
- ignoriere 75% des Gegenbeispiels und substituiere alle anderen Zustandsvariablen,
- ignoriere 75% des Gegenbeispiels und substituiere 75% der anderen Zustandsvariablen,
- ignoriere 75% des Gegenbeispiels und substituiere 25% der anderen Zustandsvariablen,
- ignoriere 75% des Gegenbeispiels und substituiere keine anderen Zustandsvariablen,
- benutze das gesamte Gegenbeispiel und substituiere alle anderen Zustandsvariablen und
- benutze das gesamte Gegenbeispiel und substituiere keine anderen Zustandsvariablen.

Das beschriebene Verfahren wurde implementiert und mehrfach im Bereich der Validierung von Gegenbeispielen eingesetzt.

Exemplarisch wurde ein Modul mit 2843 Eingängen, 4178 Ausgängen und 150215 Zustandsvariablen zugrunde gelegt. Der Schaltkreis bestand aus über 1.9 Millionen Gattern. Eine vollständige Erreichbarkeitsanalyse war mit BDD-Techniken nicht möglich. Durch die beschriebenen Überapproximationen konnte die Nicht-Erreichbarkeit von Gegenbeispielen jedoch in weniger als einer CPU Sekunde nachgewiesen werden. Die damit verbundene große Zeitersparnis für den Benutzer ist offensichtlich.

## Patentansprüche

1. Verfahren zum Äquivalenzvergleich digitaler Schaltungen, wobei jede digitale Schaltung durch eine Mehrzahl von zunächst als frei belegbar angenommenen Zustandsvariablen sowie Eingangsvariablen und Ausgangsvariablen beschrieben wird und bei Feststellung eines Unterschiedes ein Gegenbeispiel generiert wird, welches zum Nachweis einer Inäquivalenz validiert wird, indem versucht wird,
- zunächst auf Basis von Simulationen eine Erreichbarkeit des Gegenbeispiels nachzuweisen, indem eine Sequenz von Mustern gesucht wird, die ausgehend von vollständig unspezifizierten Zustandsvariablen die für dieses Muster notwendige Belegung einstellt, und
- sofern dies nicht gelingt die Nicht-Erreichbarkeit dieses Gegenbeispiels durch eine Überapproximation zu beweisen, indem ausgehend von den möglichen Ziel-Zuständen (ce) des Gegenbeispiels iterativ solange vorausgehende Zustände, von denen aus die Ziel-Zustände (ce) erreichbar sind, ermittelt werden und einer Menge von Zuständen hinzugefügt werden, bis keine neuen Zustände mehr hinzugefügt werden können, wobei Nicht-Erreichbarkeit vorliegt, wenn in der Menge von Zuständen nicht alle Zustände erreicht wurden und damit die Zielzustände des Gegenbeispiels von jedem Ausgangszustand nicht erreichbar sind.

2. Verfahren zum Äquivalenzvergleich digitaler Schaltungen nach Anspruch 1, wobei die Überapproximation auf Grundlage einer BDD (Binary Decision Diagramm)-Analyse erfolgt.

3. Verfahren zum Äquivalenzvergleich digitaler Schaltungen nach Anspruch 1 oder 2, wobei ein Nachweis der Erreichbarkeit des Gegenbeispiels auf der Grundlage von Zufallsmustersimulationen erfolgt, indem zunächst alle Zustandsvariablen mit einem unbestimmten Wert (don't care dc) belegt werden und Folgezustände iterativ ermittelt werden, indem die Eingangsvariablen der digitalen Schaltung solange mit Zufallswerten beaufschlagt werden, bis der gewünschte Zielzustand des Gegenbeispiels erreicht wird oder eine vorgegebene Anzahl von Iterationen überschritten wird.

4. Verfahren zum Äquivalenzvergleich digitaler Schaltungen nach Anspruch 1 oder 2, wobei ein Nachweis der Erreichbarkeit des Gegenbeispiels auf der Grundlage von evolutionären Algorithmen erfolgt.

5. Verfahren zum Äquivalenzvergleich digitaler Schaltungen nach einem der Ansprüche 1 bis 4, wobei zum Nachweis der Nicht-Erreichbarkeit die Überapproximation erfolgt, indem ein relevanter Systemteil des Gegenbeispiels extrahiert wird,
- wobei eine Teilschaltung generiert wird, indem eine Beschränkung auf solche schwierigen Zustandsvariablen erfolgt, die stets oder häufig auf einem unbestimmten Wert verbleiben,
- wobei bei Nicht-Erreichbarkeit der Teilschaltung auf eine Nicht-Erreichbarkeit des gesamten Gegenbeispiels geschlossen wird.

6. Verfahren zum Äquivalenzvergleich digitaler Schaltungen nach Anspruch 5, wobei eine Beschränkung auf solchermaßen schwierige Zustandsvariablen erfolgt, indem das Gegenbeispiel um alle oder einen Teil solcher Zustandsvariablen reduziert wird, die häufig den geforderten Zielzustand des Gegenbeispiels einnehmen.

7. Verfahren zum Äquivalenzvergleich digitaler Schaltungen nach Anspruch 6, wobei eine Reduzierung des Gegenbeispiels um Zustandsvariablen, die häufig den geforderten Zielzustand des Gegenbeispiels einnehmen, **dadurch** erfolgt, dass diese auf einen unbestimmten Wert (dc) gesetzt werden.

8. Verfahren zum Äquivalenzvergleich digitaler Schaltungen nach Anspruch 6 oder 7, wobei solche Zustandsvariablen, die häufig den geforderten Zielzustand des Gegenbeispiels einnehmen, auf Grundlage einer Zufallsmustersimulation nach Anspruch 3 ermittelt werden.

9. Verfahren zum Äquivalenzvergleich digitaler Schaltungen nach einem der Ansprüche 1 bis 4, wobei zum Nachweis der Nicht-Erreichbarkeit die Überapproximation erfolgt, indem ein relevanter Systemteil des Gegenbeispiels extrahiert wird,
- wobei eine Teilschaltung generiert wird, indem Zustandsvariablen durch Eingangsvariablen substituiert werden,
- wobei bei Nicht-Erreichbarkeit der Teilschaltung auf eine Nicht-Erreichbarkeit des gesamten Gegenbeispiels geschlossen wird.

10. Verfahren zum Äquivalenzvergleich digitaler Schaltungen nach Anspruch 9, wobei eine inkrementelle Substitution solcher Zustandsvariablen durch Eingangsvariablen erfolgt, die ausgehend von allen Zustandsvariablen, die im Einflussgebiet des Gegenbeispiels liegen, von der größten Anzahl an Variablen abhängen.

11. Verfahren zum Äquivalenzvergleich digitaler Schaltungen nach einem der Ansprüche 1 bis 4, wobei eine erste Überapproximation nach einem der Ansprüche 5 bis 8 erfolgt und, falls so noch keine Nicht-Erreichbarkeit nachgewiesen werden konnte, eine weitere Überapproximation nach Anspruch 9 oder 10 erfolgt, wobei solche Zustandsvariablen, die im Gegenbeispiel belegt sind, nicht durch Eingangsvariablen substituiert werden.

12. Verfahren zum Äquivalenzvergleich digitaler Schaltungen nach einem der Ansprüche 9 bis 11, wobei der Grad der Überapproximation vorgebbar ist, indem die Anzahl der zu substituierenden Zustandsvariablen variiert wird.

13. Verfahren zum Äquivalenzvergleich digitaler Schaltungen nach Anspruch 12, wobei zunächst ein maximaler Grad an Überapproximation erfolgt, welcher sukzessive verringert wird.

14. Verfahren zum Äquivalenzvergleich digitaler Schaltungen nach Anspruch 12 oder 13, wobei folgende Sequenz einer Überapproximation verwendet wird, bis eine Nicht-Erreichbarkeit nachgewiesen ist:
- ignoriere 75% des Gegenbeispiels und substituiere alle anderen Zustandsvariablen,
- ignoriere 75% des Gegenbeispiels und substituiere 75% der anderen Zustandsvariablen,
- ignoriere 75% des Gegenbeispiels und substituiere 25% der anderen Zustandsvariablen,
- ignoriere 75% des Gegenbeispiels und substituiere keine anderen Zustandsvariablen,
- benutze das gesamte Gegenbeispiel und substituiere alle anderen Zustandsvariablen und
- benutze das gesamte Gegenbeispiel und substituiere keine anderen Zustandsvariablen.

15. Verfahren zum Äquivalenzvergleich digitaler Schaltungen nach einem der Ansprüche 5 bis 14, wobei das Gegenbeispiel in eine Mehrzahl von Abstraktionsebenen (A1...A4) unterschiedliche Komplexität unterteilt ist und wobei zur Komplexitätsreduktion die Abstraktionsebene, auf der eine Simulation durchgeführt wurde, als Grundlage dient und nur an relevanten Stellen einer niedrigeren Abstraktionsebene des Gegenbeispiels diese Abstraktionsebene lokal (L) durchbrochen wird und entsprechende höherkomplexe Systeminformation des Gegenbeispiels einbezogen wird, wobei eine Validierung nur auf dem extrahierten relevanten Systemteil des Gegenbeispiels erfolgt.

16. Verfahren zum Äquivalenzvergleich digitaler Schaltungen nach einem der Ansprüche 1 bis 15, wobei Information, die bei einem Nachweis der Erreichbarkeit des Gegenbeispiels erhalten wird, zur Beschleunigung der anschließenden Nicht-Erreichbarkeis-Analyse verwendet wird.

17. Verfahren zum Äquivalenzvergleich digitaler Schaltungen nach einem der Ansprüche 1 bis 16, wobei der Erreichbarkeitsanalyse des generierten Gegenbeispiels eine Komprimierung des Gegenbeispiels vorausgeht, indem für jede Zustandsvariable und jede Eingangsvariable mit nicht unbestimmtem Wert (dc) dieser Wert auf einen unbestimmten Wert (dc) gelegt wird, worauf diese Zustandsvariable oder Eingangsvariable entfernt wird, wenn weiterhin der festgestellte Unterschied zwischen den zu überprüfenden digitalen Schaltungen auftritt, solange bis keine weitere Reduzierung mehr möglich ist.

18. Verfahren nach einem der Ansprüche 1 bis 17, dessen Verfahrensschritte mit Softwareabschnitten eines Computersystems ausgeführt werden, wenn diese Softwareabschnitte auf dem Computersystem ausgeführt werden.

19. Verwendung des Verfahrens nach einem der vorangehenden Ansprüche zur Logikverifikation im computergestützten Schaltkreisentwurf.

## Claims

1. Method for equivalence comparison of digital circuits, whereby each digital circuit is described by a plurality of state variables initially assumed as freely assignable as well as input variables and output variables and whenever a difference is found, a counter-example is generated, which is validated for proving inequivalence, by attempt being made,
- to prove initially on the basis of simulations, reachability of the counter-example, by searching for a sequence of patterns, which sets the assignment necessary for this pattern based on completely unspecified state variables, and
- if this does not succeed in proving non-reachability of this counter-example by an over approximation, by iteratively determining on the basis of the possible target states (ce) of the counter-example previous states, from which the target states (ce) can be reached, and adding them to a quantity of states until no further new states can be added, whereby non-reachability is the case, if not all the states in the quantity of states were reached and therefore the target states of the counter-example cannot be reached by each starting state.

2. Method for equivalence comparison of digital circuits according to claim 1, whereby the over approximation takes place on the basis of a BDD (Binary Decision Diagram)-analysis.

3. Method for equivalence comparison of digital circuits according to claim 1 or 2, whereby the reachability of the counter-example is proven on the basis of random pattern simulations, by initially assigning all state variables with an indefinite value (don't care dc) and by iteratively determining subsequent states, by biasing the input variables of the digital circuit with random values until the desired target state of the counter-example is reached or a specified number of iterations is exceeded.

4. Method for equivalence comparison of digital circuits according to claim 1 or 2, whereby the reachability of the counter-example is proven on the basis of evolutionary algorithms.

5. Method for equivalence comparison of digital circuits according to anyone of claims 1 to 4, whereby for proving the non-reachability the over approximation takes place by extracting a relevant part of the system of the counter-example,
- whereby a partial circuit is generated, by a limitation to such difficult state variables, which always or often remain at an indefinite value, taking place,
- whereby in the case of non-reachability of the partial circuit, non-reachability of the entire counter-example is concluded.

6. Method for equivalence comparison of digital circuits according to claim 5, whereby a limitation to such difficult state variables takes place, by reducing the counter-example by all or part of such state variables, which frequently assume the demanded target state of the counter-example.

7. Method for equivalence comparison of digital circuits according to claim 6, whereby a reduction of the counter-example by the state variables, which frequently assume the demanded target state of the counter-example, takes place by setting these to an indefinite value (dc).

8. Method for equivalence comparison of digital circuits according to claim 6 or 7, whereby such state variables, which frequently assume the demanded target state of the counter-example, are determined on the basis of a random pattern simulation according to claim 3.

9. Method for equivalence comparison of digital circuits according to anyone of claims 1 to 4, whereby for proving non-reachability the over approximation takes place, by extracting a relevant part of the system of the counter-example,
- whereby a partial circuit is generated, by replacing state variables with input variables,
- whereby in the case of non-reachability of the partial circuit, non-reachability of the entire counter-example is concluded.

10. Method for equivalence comparison of digital circuits according to claim 9, whereby such state variables are incrementally substituted with input variables, which on the basis of all state variables, that lie within the sphere of influence of the counter-example, depend on the greatest number of variables.

11. Method for equivalence comparison of digital circuits according to anyone of claims 1 to 4, whereby a first over approximation according to anyone of claims 5 to 8 takes place and, if still no non-reachability could be proven, a further over approximation according to claim 9 or 10 takes place, whereby such state variables, which are assigned in the counter-example, are not substituted with input variables.

12. Method for equivalence comparison of digital circuits according to anyone of claims 9 to 11, whereby the degree of over approximation can be specified, by varying the number of state variables to be substituted.

13. Method for equivalence comparison of digital circuits according to claim 12, whereby a maximum degree of over approximation initially takes place, which is gradually reduced.

14. Method for equivalence comparison of digital circuits according to claim 12 or 13, whereby the following sequence of an over approximation is used until non-reachability is proven:
- ignore 75% of the counter-example and substitute all other state variables,
- ignore 75% of the counter-example and substitute 75% of the other state variables,
- ignore 75% of the counter-example and substitute 25% of the other state variables,
- ignore 75% of the counter-example and substitute no other state variables,
- use the entire counter-example and substitute all other state variables and
- use the entire counter-example and substitute no other state variables.

15. Method for equivalence comparison of digital circuits according to anyone of claims 5 to 14, whereby the counter-example is divided into a plurality of abstraction levels (A1... A4) of varying complexity and whereby for reducing complexity the abstraction level, on which a simulation was carried out, serves as the basis and is only broken down locally (L) in relevant places of a lower abstraction level of the counter-example and corresponding higher-complex system information of the counter-example is included, whereby validation only concerns the relevant part of the system of the counter-example extracted.

16. Method for equivalence comparison of digital circuits according to anyone of claims 1 to 15, whereby information, which is obtained when proving reachability of the counter-example, is used for accelerating the subsequent non-reachability analysis.

17. Method for equivalence comparison of digital circuits according to anyone of claims 1 to 16, whereby compression of the counter-example precedes the reachability analysis of the counter-example generated, by assigning for each state variable and each input variable with not indefinite value (dc), an indefinite value (dc) to this value, whereupon this state variable or input variable is eliminated whenever the difference determined between the digital circuits to be checked continues to arise, for such time until no further reduction is possible.

18. Method according to anyone of claims 1 to 17, the method steps of which are carried out with software sections of a computer system when the software sections are executed on the computer system.

19. Use of the method according to anyone of the preceding claims for verifying the logic in computer-assisted circuit design.

## Revendications

1. Procédé de comparaison par équivalence de circuits numériques, dans lequel chaque circuit numérique est décrit par plusieurs variables d'état d'abord admises comme pouvant être librement affectées, ainsi que par des variables d'entrée et des variables de sortie, et lorsqu'on constate une différence, on génère un contre-exemple qui est validé pour prouver une non-équivalence, en essayant,
- tout d'abord sur la base de simulations, de prouver une accessibilité du contre-exemple, en recherchant une séquence de modèles qui, en partant de variables d'état entièrement non spécifiées, établit l'occupation nécessaire pour ce modèle, et
- si cela ne réussit pas, de prouver la non-accessibilité de ce contre-exemple par une surapproximation, en ce que, en partant des états cible possibles (ce) du contre-exemple, on détermine par itération des états précédents depuis lesquels on peut accéder aux états cible (ce), et on ajoute une quantité d'états jusqu'à ce que l'on ne puisse plus ajouter de nouveaux états, suite à quoi il existe une non-accessibilité lorsque, dans la quantité d'états, tous les états n'ont pas été atteints et que, par conséquent, les états cible du contre-exemple ne sont pas accessibles depuis chaque état de sortie.

2. Procédé de comparaison par équivalence de circuits numériques selon la revendication 1, dans lequel la surapproximation se fait sur la base d'une analyse BDD (Binary Decision Diagramm).

3. Procédé de comparaison par équivalence de circuits numériques selon la revendication 1 ou 2, dans lequel une preuve de l'accessibilité du contre-exemple se fait sur la base de simulations aléatoires de modèles, en ce que d'abord toutes les variables d'état sont occupées par une valeur indéterminée (don't care dc) et les états suivants sont déterminés par itération, en ce que les variables d'entrée du circuit numérique sont chargées de valeurs aléatoires jusqu'à ce que l'état cible souhaité du contre-exemple soit atteint ou qu'un nombre prédéfini d'itérations soit dépassé.

4. Procédé de comparaison par équivalence de circuits numériques selon la revendication 1 ou 2, dans lequel une preuve de l'accessibilité du contre-exemple se fait sur la base d'algorithmes évolutifs.

5. Procédé de comparaison par équivalence de circuits numériques selon l'une des revendications 1 à 4, dans lequel, pour prouver la non-accessibilité, on réalise la surapproximation en extrayant un élément de système pertinent du contre-exemple,
- un circuit partiel étant alors généré par le fait qu'il se produit une limitation à des variables d'état difficiles qui restent toujours ou souvent à une valeur indéterminée,
- suite à quoi, en cas de non-accessibilité du circuit partiel, on conclut à une non-accessibilité de l'ensemble du contre-exemple.

6. Procédé de comparaison par équivalence de circuits numériques selon la revendication 5, dans lequel on réalise une limitation à de telles variables d'état difficiles en réduisant le contre-exemple de la totalité ou d'une partie de ces variables d'état qui occupent souvent l'état cible exigé du contre-exemple.

7. Procédé de comparaison par équivalence de circuits numériques selon la revendication 6, dans lequel une réduction du contre-exemple des variables d'état qui occupent souvent l'état cible exigé du contre-exemple, se fait de façon telle que celles-ci prennent une valeur indéterminée (dc).

8. Procédé de comparaison par équivalence de circuits numériques selon la revendication 6 ou 7, dans lequel de telles variables d'état, qui occupent souvent l'état cible exigé du contre-exemple, sont déterminées sur la base d'une simulation aléatoire de modèles selon la revendication 3.

9. Procédé de comparaison par équivalence de circuits numériques selon l'une des revendications 1 à 4, dans lequel, pour prouver la non-accessibilité, on réalise la surapproximation en extrayant une partie de système pertinente du contre-exemple,
- un circuit partiel étant alors généré par substitution de variables d'état par de variables d'entrée,
- suite à quoi, en cas de non-accessibilité du circuit partiel, on conclut à une non-accessibilité de l'ensemble du contre-exemple.

10. Procédé de comparaison par équivalence de circuits numériques selon la revendication 9, dans lequel on réalise une substitution incrémentielle par des variables d'entrée, des variables d'état qui, en partant de toutes les variables d'état qui sont dans le domaine d'influence du contre-exemple, dépendent du plus grand nombre de variables.

11. Procédé de comparaison par équivalence de circuits numériques selon l'une des revendications 1 à 4, dans lequel on réalise une première surapproximation selon l'une des revendications 5 à 8 et, et si on n'a pas encore ainsi pu prouver une non-accessibilité, on réalise une autre surapproximation selon la revendication 9 ou 10, les variables d'état, qui sont occupées dans le contre-exemple, n'étant pas substituées par des variables d'entrée.

12. Procédé de comparaison par équivalence de circuits numériques selon l'une des revendications 9 à 11, dans lequel le degré de surapproximation peut être prédéfini par modification du nombre des variables d'état à substituer.

13. Procédé de comparaison par équivalence de circuits numériques selon la revendication 12, dans lequel on réalise d'abord un degré maximum de surapproximation, qui fait l'objet de diminutions successives.

14. Procédé de comparaison par équivalence de circuits numériques selon la revendication 12 ou 13, dans lequel on utilise la séquence suivante d'une surapproximation jusqu'à ce que soit prouvée une non-accessibilité :
- ignorer 75 % du contre-exemple et substituer toutes les autres variables d'état,
- ignorer 75 % du contre-exemple et substituer 75 % des autres variables d'état,
- ignorer 75 % du contre-exemple et substituer 25 % des autres variables d'état,
- ignorer 75 % du contre-exemple et ne substituer aucune autre variable d'état,
- utiliser la totalité du contre-exemple et substituer toutes les autres variables d'état, et
- utiliser la totalité du contre-exemple et ne substituer aucune autre variable d'état.

15. Procédé de comparaison par équivalence de circuits numériques selon l'une des revendications 5 à 14, dans lequel le contre-exemple est subdivisé en plusieurs plans d'abstraction (A1... A4) de complexités différentes, et dans lequel, pour réduire la complexité, on utilise comme base le plan d'abstraction sur lequel on a réalisé une simulation, et seul ce plan d'abstraction n'est localement (L) transpercé qu'au niveau de points pertinents d'un plan d'abstraction plus bas du contre-exemple, et on incorpore des informations de système plus complexes correspondantes du contre-exemple, une validation ne se faisant que sur la partie de système pertinente extraite du contre-exemple.

16. Procédé de comparaison par équivalence de circuits numériques selon l'une des revendications 1 à 15, dans lequel on utilise des informations qui sont obtenues lors d'une preuve de l'accessibilité du contre-exemple, pour accélérer l'analyse suivante de non-accessibilité.

17. Procédé de comparaison par équivalence de circuits numériques selon l'une des revendications 1 à 16, dans lequel l'analyse d'accessibilité du contre-exemple généré précède une compression du contre-exemple en ce que, pour chaque variable d'état et chaque variable d'entrée ayant une valeur non indéterminée (dc), on place cette valeur sur une valeur indéterminée (dc), suite à quoi on retire cette variable d'état ou variable d'entrée lorsqu'apparaît de plus la différence constatée entre les circuits numériques à contrôler, et ce jusqu'à ce qu'une réduction supplémentaire ne soit plus possible.

18. Procédé selon l'une des revendications 1 à 17, dont les étapes opératoires sont exécutées avec des segments logiciels d'un système informatique lorsque ces segments logiciels sont exécutés sur le système informatique.

19. Utilisation du procédé selon l'une des revendications précédentes pour la vérification de la logique dans la proposition de circuit assistée par ordinateur.
